# EUROPEAN PATENT SPECIFICATION

(11) **EP 1 430 520 B1**
(45) Date of publication and mention of the grant of the patent: **27.04.2011**
(21) Application number: 01965709.7
(22) Date of filing: 29.08.2001
(51) Int. Cl.: H01L 21/304, B24D 13/14, B24B 37/04

(54) **CHEMICAL MECHANICAL POLISHING PAD WITH MICRO-HOLES**
CHEMISCHES MECHANISCHES POLIERSTÜCK MIT MIKROLÖCHERN
TAMPON DE POLISSAGE CHIMIQUE ET MECANIQUE POURVU DE MICRO-TROUS

(30) Priority: 02.08.2001 KR 2001046796
(43) Date of publication of application: 23.06.2004
(73) Proprietor: SKC Co., Ltd., Suwon-si, Kyungki-do 440-300 (KR)
(72) Inventor: PARK, In-Ha, Joong-ku, Ulsan 681-816 (KR); KWON, Tae-Kyoung, Joong-ku, Ulsan 681-816 (KR); KIM, Jae-Seok, Joong-ku, Ulsan 681-816 (KR)
(74) Representative: Vidon, Patrice
(86) International application number: PCT/KR2001/001463
(87) International publication number: WO 2003/012846

(56) References cited:
- EP-A- 0 439 124
- EP-A- 0 622 155
- JP-A- 2 088 165
- JP-A- 11 099 468
- JP-A- 2000 117 620
- JP-A- 2001 071 256
- US-A- 6 165 904

## Description

### Technical Field

The present invention relates to a polishing pad used in a chemical mechanical polishing process, and more particularly to a polishing pad formed with micro-holes at the surface thereof.

### Background Art

Generally, chemical mechanical polishing (CMP) is a high precision/mirrored surface polishing method used to obtain global planarization in a semiconductor device manufacturing process. In accordance with such CMP, a slurry is supplied between a polishing pad and a wafer to be polished, so as to chemically etch the surface of the wafer. Using the polishing pad, the etched surface of the wafer is mechanically polished.

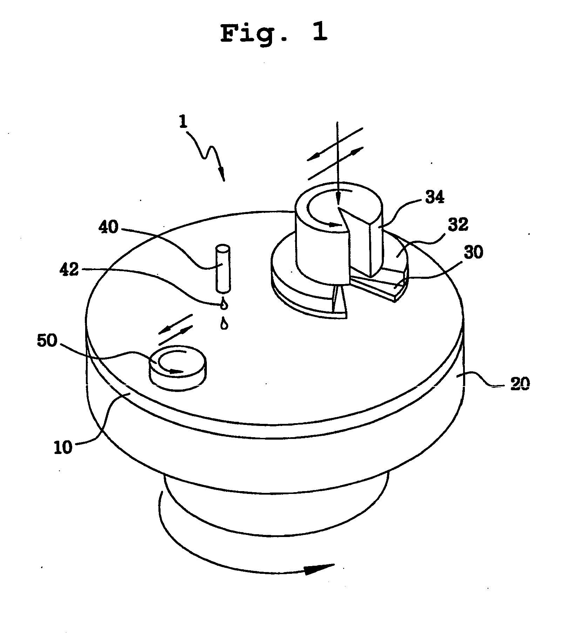

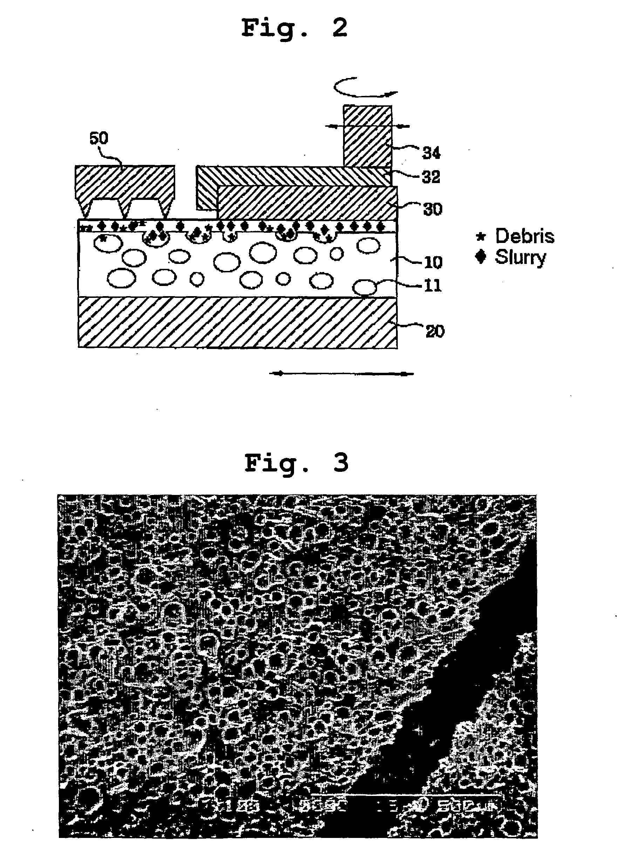

Referring to Fig. 1, a typical CMP machine, which is denoted by the reference numeral 1, is schematically illustrated. Also, a CMP method using the CMP machine 1 is schematically illustrated in Fig. 2. The CMP method includes a chemical etching reaction process and a mechanical polishing process, which are conducted using a polishing pad 10 included in the CMP machine 1. The chemical etching reaction is carried out by a slurry 42. That is, the slurry 42 serves to chemically react with the surface of a wafer 30 to be polished, thereby making it possible for the mechanical polishing process, following the chemical etching reaction, to be easily carried out. In the mechanical polishing process, the polishing pad 10, which is fixedly mounted on a platen 20, rotates. The wafer 30, which is firmly held by a retainer ring 32, rotates while oscillating. A slurry containing abrasive particles is supplied to the polishing pad 10 by a slurry supply means 40. The supplied slurry is introduced between the polishing pad 10 and the wafer 30. The introduced abrasive particles come into frictional contact with the wafer 30 by virtue of a relative rotating speed difference between the polishing pad 10 and the wafer 30, so that they conduct mechanical polishing. The slurry 42 is a colloidal liquid containing abrasive particles having a grain size of nanometers. This slurry 42 is spread on the polishing pad 10 during the polishing process. As the polishing pad 10 rotates during the polishing process, the slurry 42 supplied to the polishing pad 10 is outwardly discharged from the periphery of the polishing pad 10 due to a centrifugal force caused by the rotation of the polishing pad 10. In order to achieve an enhanced polishing efficiency, many abrasive particles should remain for a desirable lengthy period of time on the upper surface of the polishing pad 10 so that they participate in the polishing of the wafer. That is, the polishing pad 10 should make the slurry 42 be held on the surface thereof for as long a period of time as possible.

In order to make the slurry be held on the polishing pad for a long period of time, a method has been proposed which forms spherical microcells having a diameter of micrometers (µm). The slurry supplied onto the polishing pad during a polishing process is stored in the microcells, and flows out from the microcells due' to a pressure from a wafer applied thereto. Thus, the slurry participates in the polishing of the wafer. The microcells also serve to store debris separated from the wafer during the polishing process. The debris stored in the microcells is outwardly pumped out when.the polishing pad is conditioned.

Conventionally, the formation of microcells at the polishing pad is achieved using a physical method in which hollow microelements each having a cavity are physically incorporated in a polymeric matrix to form microcells, or a foaming method in which bubbles are chemically formed to form microcells.

The incorporation of microelements in a polymeric matrix is achieved by impregnating a large amount of microelements each having a cavity into a polymeric matrix in such a fashion that the microelements are uniformly distributed in the polymeric matrix, thereby forming microcells. The polymeric matrix is prepared by mixing a curing agent with a resin such as urethane, polyester, fluorinated hydrocarbon, or a mixture thereof. For the microelements, inorganic salt, sugar, water soluble gum, or resin is mainly used. Such microelements are made of polyvinylalcohol, pectin, polyvinyl pyrrolidone, polyethylene glycol, polyurethane or a combination thereof. Such microelements have an average diameter of about 150 µm. The microelements are uniformly distributed over the polymeric matrix in accordance with a high shear mixing process, so that they form uniform microcells. Referring to Fig. 3, microcells formed using the cavity bodies are illustrated. The pad formed with microcells in the above mentioned manner is subsequently cut into pieces each having a desired thickness to obtain a polishing pad. In each cut piece, microcells randomly distributed in the pad are opened at the cut surfaces of the cut piece, so that they are exposed in the form of a circular or oval cross section at the cut surfaces of the cut piece. The sizes and positions of the micro-cell cross sections exposed at the polishing surface of each polishing pad are random. Such random size and position of the exposed microcell cross sections serves to degrade a desired uniformity among polishing pads.

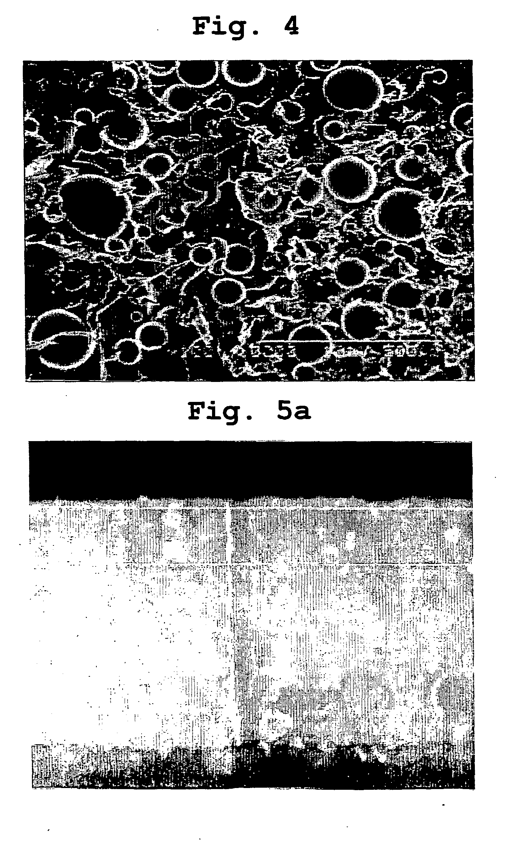

In accordance with the chemical method in which cells are formed using a foaming process, a polymeric matrix is formed by mixing a curing agent with a liquid-phase polyurethane forming substance having a low boiling point. Water or liquefied gas, which directly takes part in a chemical reaction to generate gas, is also used as a foaming agent, thereby producing bubbles to form cells in the polymeric matrix. The production of bubbles is achieved by way of a nucleation caused by a high shear mixing operation. A surfactant, which serves to achieve a reduction in surface tension, is also used to adjust the size of microcells, thereby achieving a desired uniformity of micro-cells. Microcells formed using the foaming process are shown in Fig. 4. As seen in Fig. 4, this method has a disadvantage in that it is impossible to form microcells having a uniform size on the polishing pad. Since the microcells formed in accordance with the foaming process exhibit expansion characteristics which vary depending on a variation in temperature to which they are subjected, they may vary in size depending on an amount of heat generated in a curing process.

The microcells formed using microelements each having a cavity or a foaming process have a spherical structure having a circular or oval cross-sectional shape. Due to such a shape, the microcells have a cross section varying in the thickness direction of the polishing pad. For this reason, the cross section of each microcell exposed at the polishing surface of the polishing pad is varied as the polishing pad is abraded during a polishing process. In other words, circular or oval microcells exposed at the polishing surface of the polishing pad are gradually reduced in diameter as the polishing process proceeds, and finally disappear. Eventually, microcells existing below the surface of the polishing pad without being exposed, are newly exposed at the polishing surface of the polishing pad.

Thus, the cross section of each microcell exposed at the polishing surface of the polishing pad is varied as the polishing pad varies in thickness during the polishing process. For this reason, there is a problem in that the polishing rate is non-uniform.

Document JP 2001 071256 A discloses a chemical mechanical polishing pad, wherein the pad has micro-holes, each formed by a laser and having a desired depth and a desired uniform cross-sectional area at a polishing surface thereof.

Documents US 6 165 904 A and EP 0 439 124 A disclose a chemical mechanical polishing pad, wherein the pad has micro-holes having a desired depth and a desired uniform cross-sectional area at a polishing surface thereof, wherein the pad is divided into at least two micro-hole regions to the radial direction where the micro-holes are distributed while having different cross-sectional areas, different shapes, and/or different densities, respectively.

Document JP 2 088165 A discloses a chemical mechanical polishing pad, wherein the pad has micro-holes, having a desired depth and a desired cross-sectional area at a polishing surface thereof, each of the micro-holes are inclined from the polishing surface.

### Disclosure of the Invention

Therefore, the present invention has been made in order to solve the problems involved with microcells formed using microelements each having a cavity or a foaming process. The present invention proposes a polishing pad having micro-holes capable of effectively storing and discharging a slurry to maintain a desired polishing rate while performing the same function as microcells.

An object of the invention is to provide a polishing pad having micro-holes of a uniform size distributed to have a pattern selected from diverse patterns by the user, the micro-holes maintaining a desired cross-sectional area irrespective of a variation in the thickness of the polishing pad occurring during a polishing process.

Another object of the invention is to provide a polishing pad having micro-holes having a controlled size, shape and density, thereby being capable of securing an optimal processing condition to achieve an improvement in polishing efficiency.

In order to accomplish these objects, the present invention provides a CMP pad according to claim 1.

### Brief Description of the Drawings

The above objects, and other features and advantages of the present invention will become more apparent after a reading of the following detailed description when taken in conjunction with the drawings, in which:
Fig. 1 is a schematic view illustrating the configuration of a typical CMP machine and a polishing method performed using the CMP machine;
Fig. 2 is a schematic view illustrating the concept of a CMP method;
Fig. 3 is a photograph of microcells formed using microelements each having a cavity;
Fig. 4 is a photograph of microcells formed using a foaming method;
Fig. 5a is a photograph showing the cross-sectional structure of micro-holes formed in accordance with the present invention;
Fig. 5b is a photograph showing the plan structure of micro-holes formed in accordance with the present invention;
Fig. 6 is a schematic view illustrating micro-holes formed to have an angle with respect to a polishing surface in accordance with the present invention;
Fig. 7a is a concept diagram illustrating an arrangement of micro-holes according to the present invention;
Figs. 7b and 7c illustrate examples of micro-hole arrangements according to the present invention, respectively; and
Fig. 8 is a schematic view illustrating a polishing pad according to the present invention having radial micro-hole regions where micro-holes are distributed while having different densities, respectively.

### Best Mode for Carrying Out the Invention

Now, the present invention will be described in detail in terms of its constitution and function, with reference to the annexed drawings.

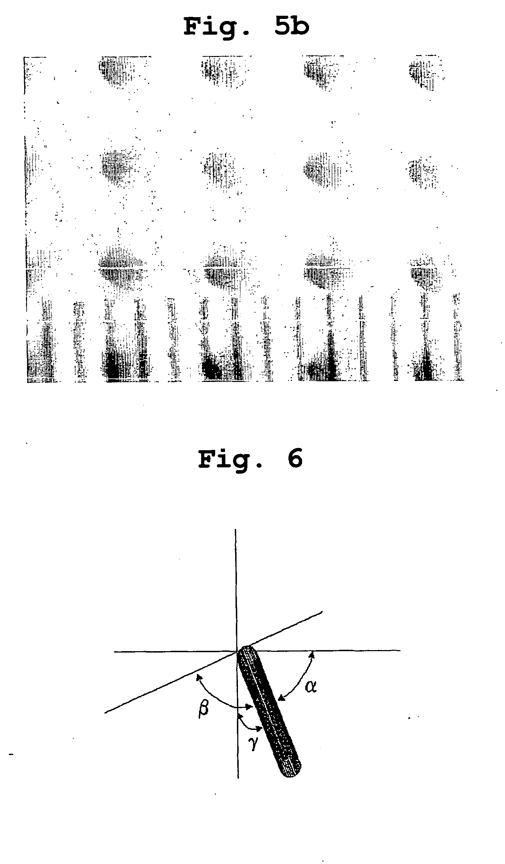

The present invention provides a CMP pad used in a CMP process and characterized by micro-holes formed at a polishing surface thereof. Each of the micro-holes according to the present invention is opened at its upper ends thereof and has a uniform cross-sectional area. Figs. 5a and 5b show the cross-sectional and plane structures of the micro-holes according to the present invention, respectively.

As shown in Figs. 5a and 5b, the micro-holes formed in accordance, with the present invention have a uniform diameter and a uniform distribution. The micro-holes of Figs- 5a and 5b have a circular cross section. However, these micro-holes may have diverse shapes such as an oval shape, a polygonal shape, for example, a triangular shape or a rectangular or square shape, and a star shape. In the cass of micro-holes having a circular cross section, they preferably have a diameter of about 10 to 200 µm.

Conventionally, the micro-holes extend in a direction perpendicular to the polishing surface of the polishing pad. However, according to the invention, they extend inclinedly with respect to the polishing surface. Referring to Fig. 6, a micro-hole is illustrated which forms angles α, β, and γ with respect to x, y, and z axes of the polishing pad, respectively. Here, the angles α, β, and γ are more than 0°, but less than 90° (0° < α, β, γ, < 90°).

Preferably, each micro-hole has a cross-sectional area ranging from about 10 µm² to 10 mm². Also, each micro-hole has a depth having a ratio ranging from 0.01:1 to 1:1 with respect' to the thickness of the polishing pad.

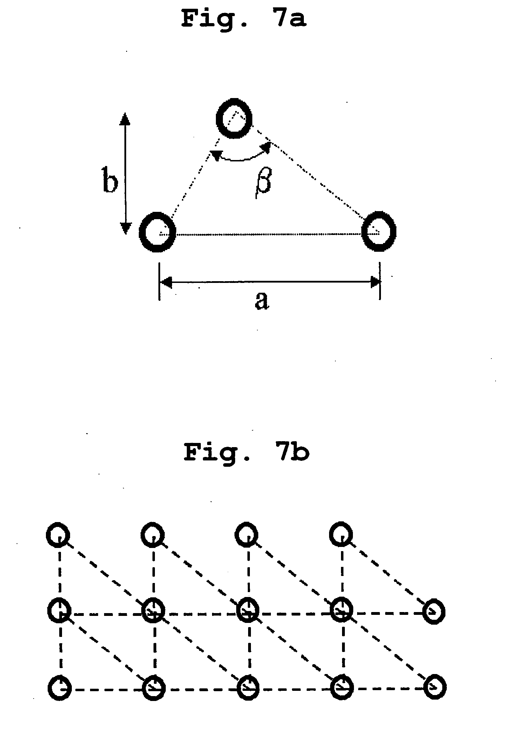

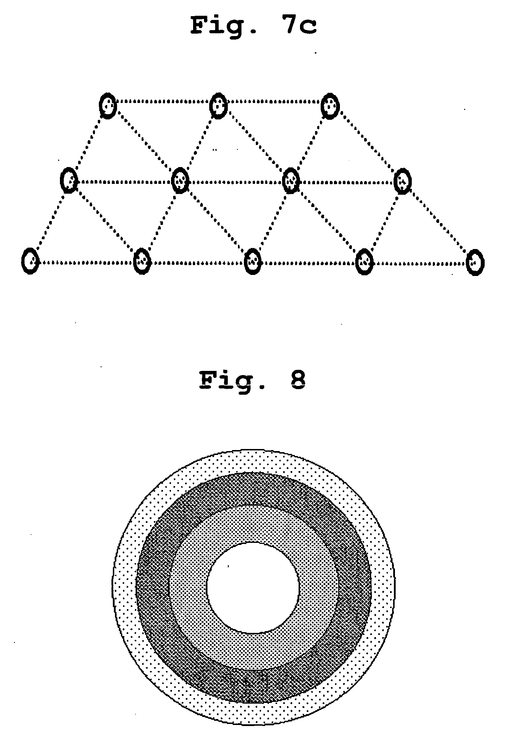

In accordance with the present invention, such micro-holes may have a triangular arrangement defined-by a base a, a height b, and an angle β between both sides; as shown in Fig. 7a. Figs. 7b and 7c illustrate examples of micro-hole arrangements based on such a triangular arrangement, respectively.

The micro-holes formed on the polishing pad according to the preset invention may have an arrangement selected from diverse arrangements in accordance with the size, density and shape desired by the user. In accordance with conventional methods using microelements each having a cavity or a conventional foaming process to form microcells, there is no means capable of adjusting the size, shape, and density of those microcells, In accordance with the present invention, however, it is possible to adjust the shape, size and density of micro holes so that they meet the optimum condition desired by the user.

Fig. 8 schematically illustrate an example of the polishing pad formed with micro-holes in accordance with the present invention. As shown in Fig. 8, the polishing pad, which has a circular shape, has four radial regions respectively having different micro-hole densities. At each radial region, micro-holes are distributed to have a uniform density, a uniform shape and a uniform cross-sectional area. Thus, the polishing pad of the present invention has an advantage in that its micro-holes are variously arranged so that they achieve the optimum processing condition.

In accordance with the present invention, the formation of micro-holes on the polishing pad is achieved by using a laser. A laser machining principle is utilized in accordance with the present invention. The laser machining method is advantageous in that it has a feature of reducing the area of a layer subjected to a thermal deformation. Also, the laser machining method is performed in a non-contact fashion, so that there is no abrasion of the tool. The laser machining method is also capable of precisely machining an article having a complex shape, eliminating generation of noise and vibrations, and maintaining a clean working environment. Also, there is an advantage in that each micro-hole formed by the laser machining method has a smooth and precise inner surface. The laser machining method provides another advantage in that it is possible to freely vary and adjust the shape, size, depth, and density of micro-holes.

The micro-holes of the present invention store the slurry supplied onto the polishing pad during the polishing process, and outwardly pump out the stored slurry by virtue of the pressure from a wafer applied thereto. Thus, the slurry participates in the polishing of the wafer. Although the polishing pad of the present invention varies in thickness as the polishing process proceeds, it can maintain a desired polishing rate because each micro-hole has a uniform cross-sectional area. In particular, the micro-holes are always in an opened state. Accordingly, it is unnecessary to manually open the micro-holes, as different from conventional microcells. The micro-holes also serve to store debris separated from the wafer during the polishing process, and to outwardly pump out the stored debris when the polishing pad is conditioned.

### Industrial Applicability

As apparent from the above description, the present invention provides a CMP pad having micro-holes capable of effectively absorbing a slurry while discharging the slurry during a polishing process to maintain a desired polishing rate.

In accordance with the present invention, it is possible to freely vary and adjust the shape, size, depth, and density of micro-holes so as to achieve the optimum processing condition. Thus, an enhancement in polishing efficiency is obtained.

Although the preferred embodiments of the invention have been disclosed for illustrative purposes in conjunction with a CMP pad formed with micro-holes, those skilled in the art will appreciate that various modifications, additions and substitutions are possible, without departing from the scope of the invention as defined by the accompanying claims.

## Claims

1. A chemical mechanical polishing pad, wherein the pad has micro-holes each formed by a laser and having a desired depth and a desired uniform cross-sectional area at a polishing surface thereof, each of the micro-holes are inclined from the polishing surface, wherein the pad is divided into at least two micro-hole regions to the radial direction where the micro-holes are distributed while having different cross-sectional areas, different shapes and/or different densities, respectively.

2. The chemical mechanical polishing pad according to claim 1, wherein each of the micro-holes has a cross-sectional shape corresponding to a circular shape, an oval shape, a triangular shape, a rectangular or square shape, a polygonal shape, or a star shape.

3. The chemical mechanical polishing pad according to claim 1, wherein the cross-sectional area of each of the micro-holes ranges from 10 µm² to 10 mm².

4. The chemical mechanical polishing pad according to claim 1, wherein the depth of each of the micro-holes has a ratio ranging from 0.01:1 to 1:1 with respect to a thickness of the pad.

## Patentansprüche

1. Chemisch-mechanische Polierscheibe, wobei auf einer Polieroberfläche der Scheibe durch einen Laser geformte Mikrolöcher ausgebildet sind, die jeweils eine gewünschte Tiefe und eine gewünschte gleichmäßige Querschnittsfläche aufweisen, wobei sich jedes der Mikrolöcher schräg zur Polieroberfläche erstreckt, und wobei die Scheibe in radialer Richtung in mindestens zwei Mikrolochbereiche unterteilt ist, auf die die Mikrolöcher verteilt sind und in denen die Mikrolöcher unterschiedliche Querschnittsflächen, unterschiedliche Formen und/oder unterschiedliche Dichten aufweisen.

2. Chemisch-mechanische Polierscheibe nach Anspruch 1,
wobei jedes der Mikrolöcher eine Querschnittsform aufweist, die kreisförmig, oval, dreieckig, rechteckig oder quadratisch, polygonal oder sternförmig ist.

3. Chemisch-mechanische Polierscheibe nach Anspruch 1,
wobei die Querschnittsfläche eines jeden der Mikrolöcher zwischen 10 µm² bis 10 mm² beträgt.

4. Chemisch-mechanische Polierscheibe nach Anspruch 1,
wobei die Tiefe eines jeden der Mikrolöcher in Bezug auf die Dicke der Scheibe ein Verhältnis zwischen 0.01:1 und 1:1 aufweist.

## Revendications

1. Tampon de polissage mécanique et chimique, dans lequel le tampon est pourvu de micro-trous chacun formés par un laser et ayant une profondeur souhaitée et une superficie transversale uniforme souhaitée sur une surface de polissage de celui-ci, chacun des micro-trous étant incliné par rapport à la surface de polissage, dans lequel le tampon est divisé en au moins deux zones de micro-trous dans la direction radiale où les micro-trous sont répartis tout en ayant des superficies transversales différentes, des formes différentes et/ou des densités différentes, respectivement.

2. Tampon de polissage mécanique et chimique selon la revendication 1, dans lequel chacun des micro-trous a une forme transversale correspondant à une forme circulaire, une forme ovale, une forme triangulaire, une forme rectangulaire ou carrée, une forme polygonale, ou une forme d'étoile.

3. Tampon de polissage mécanique et chimique selon la revendication 1, dans lequel la superficie transversale de chacun des micro-trous est comprise entre 10 µm² et 10 mm².

4. Tampon de polissage mécanique et chimique selon la revendication 1, dans lequel la profondeur de chacun des micro-trous a un rapport compris entre 0,01 :1 et 1 :1, relativement à une épaisseur du tampon.
